# EUROPEAN PATENT SPECIFICATION

(11) **EP 0 491 311 B1**
(45) Date of publication and mention of the grant of the patent: **14.08.1996**
(21) Application number: 91121497.1
(22) Date of filing: 16.12.1991
(51) Int. Cl.: H01J 37/317

(54) **Ion implanting apparatus and method**
Gerät und Verfahren zur Ionenimplantierung
Appareil et procédé pour l'implantation ionique

(30) Priority: 17.12.1990 US 628788
(43) Date of publication of application: 24.06.1992
(73) Proprietor: APPLIED MATERIALS INC., Santa Clara California 95052 (US)
(72) Inventor: Bright, Nicholas, Southwater, W. Sussex (GB); Ito, Hiroyuki, Horsham, W. Sussex RH112 2ED (GB); Morgan, Timothy Grey, Pinner, Middlesex HA5 2QY (GB)
(74) Representative: Kahler, Kurt, Dipl.-Ing.

(56) References cited:
- EP-A- 0 104 818
- US-A- 4 149 084
- US-A- 4 804 837
- US-A- 4 939 360
- RCA REVIEW. vol. 44, no. 1, March 1983, PRINCETON US, pages 48-63; C.P. WU ET AL.: 'ELECTRON-FLOOD TECHNIQUES TO NEUTRALIZE BEAM CHARGING DURING ION IMPLANTATION'

## Description

This invention relates to ion implantation of semiconductor devices. More particularly, this invention relates to a method of ion implantation and an ion implanter that reduces damage resulting from charging of the wafer during implantation.

### BACKGROUND OF THE INVENTION

Ion implantation has supplanted older methods of doping semiconductor wafers to form devices, such as diffusion, as feature sizes became smaller and the number of devices on a single wafer became larger. Ion implantation provides more control over both the number of ions in the device and the doping profile achieved. correspondingly, ion implantation equipment has become more sophisticated.

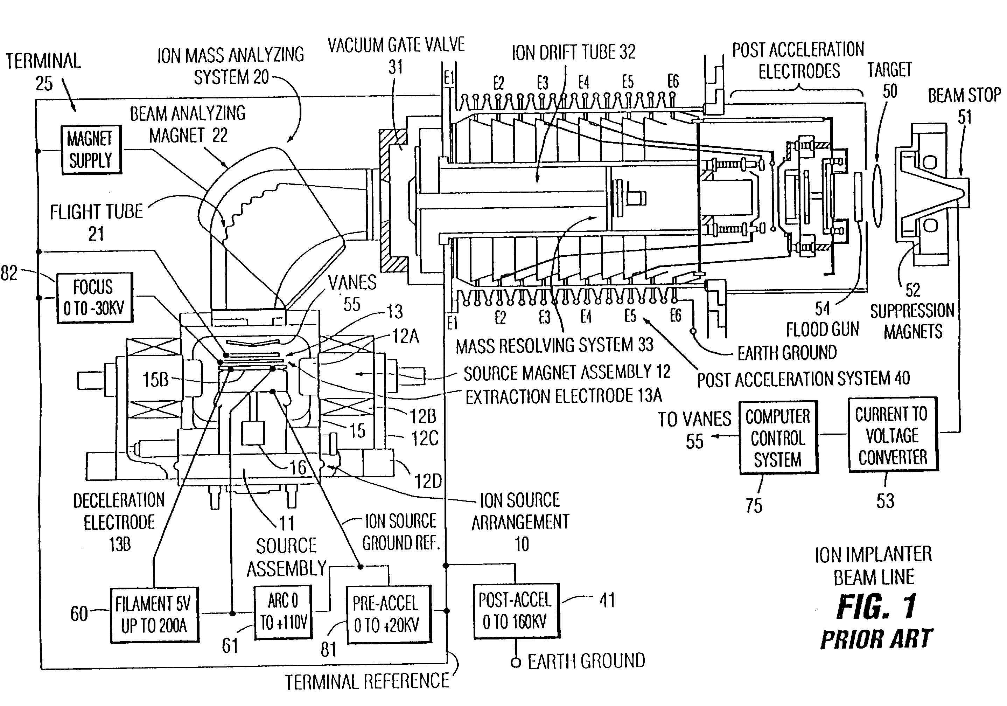

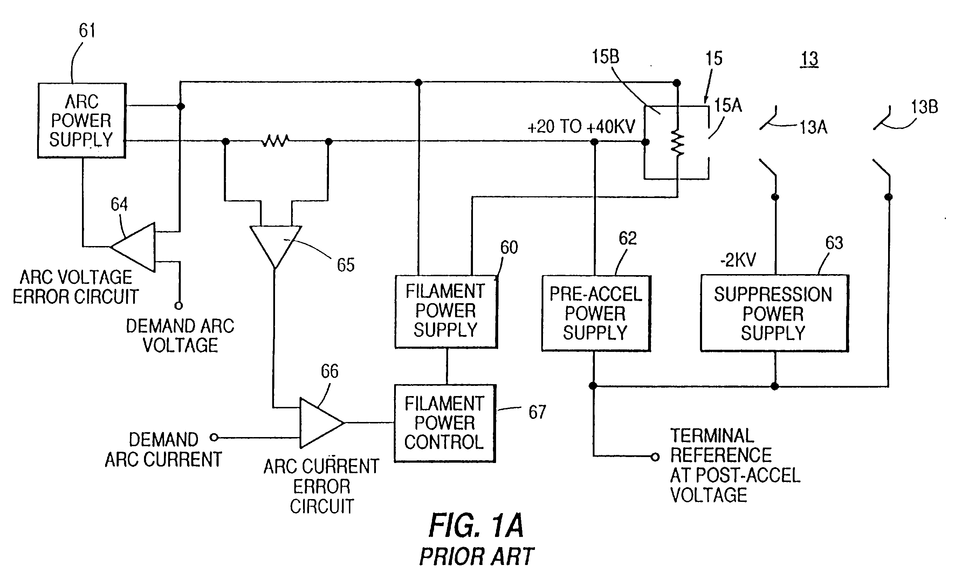

A modern ion implanter is shown in Fig. 1. Although this equipment is satisfactory for the manufacture of VLSI chips, a few problems remain.

Wafer charging is still a problem, because partly completed devices undergoing implantation can be damaged, particularly when a high dose, high current implant is to be performed. For example, in the manufacture of self-aligned MOS devices, a polysilicon layer is deposited over a gate oxide. During implantation, if the polysilicon is electrically isolated from the substrate, it will tend to accumulate positive charge and damage the underlying oxide layer.

In order to achieve high yields of semiconductor devices it is important to minimize wafer chargeup during the ion implantation step. One way of doing this is to obtain an implantation beam containing both the positive ions to be implanted and electrons, in balance, delivered to the wafer. Further, the energy of the electrons reaching the wafer must be kept low, e.g., about 20 eV or less.

The ion beam generates low energy electrons via collisions whenever a beam strikes a solid surface. A fraction of the ion beam will always strike the mass resolving system of the ion implanter, thus generating low energy electrons. These low energy electrons are trapped within the positive potential of the ion beam as soon as they are generated and are ready to be trapped and transported to the wafer whenever the wafer accumulates positie charge on its surface. However, the relative amounts of charged particles are generally unknown, and they are removed as the beam proceeds through various portions of the implanter and is acted upon by various other electrostatic and magnetic forces, both internally and externally applied. In order to reduce the positive charging effect, an electron flood device has been used to increase the number of electrons around the wafer, thereby in part neutralizing the positive charging effect of the ion beam. However, because the electrons cannot be forced to flood the exact region on the wafer where positive ions are being implanted, any particular spot on the wafer can still see a transient charging effect e.g., one that becomes negative, then positive, then negative again, with concomitant damage to the wafer and the devices being made therein. Thus there may still be a charging pulse whose magnitude is sizeable.

Further, the electron generating mechanism is independent of the ion beam in response to changes in the system, such as ion beam current changes. The number of electrons admitted to the wafer is unable to be changed rapidly enough in conventional ion implantation equipment to prevent the charging effects on the wafers being implanted.

US-A- 4 149 084 discloses an apparatus for maintaining ion bombardment beam under improved vacuum condition through the use of only a single vacuum pump for the beam line and target portions of the apparatus. This vacuum pump is disposed, at least to some extent, between the mass resolving system and the target. As vacuum pumps are provided with electric motors magnetic fields are also generated.

Furthermore, from RCA-Review, Vol. 44, No. 1, March 1983, Princeton, US, pages 48-63, C.P. WU et al.: "Electron-Flood techniques to neutralize beam charging during ion implantation" the electron production within an ion beam by ionization of a low pressure gas is known for space-charge-neutralization of the ion beam to provide efficient beam transport.

### SUMMARY OF THE INVENTION

The invention resides in an ion implanter of the kind referred to in claim 1.

The invention resides further in a method of ion implantation of the kind referred to in claim 2.

The charging of a wafer during ion implantation is greatly reduced by providing a field-free zone in the ion implanter wherein the wafer is located. This zone is free of all applied fields, whether due to electrostatic suppression/lens or magnetic suppression/lens sources.

### BRIEF DESCRIPTION OF THE DRAWING

Fig. 1 is a partial sectional view of a prior art ion beam line having a flood charge control section.

Fig. 1A is a schematic diagram of a prior art ion source control system and ion beam extraction system.

Fig. 2 is a partial sectional view of an ion implanter beam line illustrating the field-free region environment of the implanter of the present invention.

### DETAILED DESCRIPTION OF THE INVENTION

Reference will now be had to Fig. 1 and Fig. 1A for an explanation of state-of-the-art ion implantation equipment.

Fig. 1 illustrates, for purposes of example, the ion beam line subsystems of an ion implanter.

Referring to Fig. 1, ions are generated in the arc chamber 15 of a Freeman ion source. An extraction electrode assembly 13 extracts a beam of ions through a rectangular aperture 15A in the front of the arc chamber 15. The ion beam is both extracted and accelerated toward the mass analyzing system 20, which includes an ion beam flight tube 21 providing a path between the poles of an analyzing magnet assembly 22. The ion beam is bent in passing through the analyzing magnet assembly 22, enters a ion drift tube 32, passes through a mass resolving system 33, is accelerated in a post acceleration system 40, if used, and strikes a target element 50. During a portion of the scan cycle, the target element 50 is out of the beam, and all of the beam current falls on the beam stop 51. Suppression magnets 52 in the beam stop arrangement 51 produce a magnetic field oriented to prevent escape of secondary electrons from the beam stop and thus to ensure accurate measurement of the beam current. This suppression function is well known and need not be described in detail herein.

A flood gun arrangement 54, shown schematically in Fig. 1, may be positioned in the vicinity of the wafer 50 to assist with neutralizing positive charges which may otherwise build up to a destructive level on the surface of the wafer. In some cases an inert gas has been injected into the region in front of the wafer to create a plasma in that region which may assist in neutralizing the charge build up on the wafer surface.

Ion source assembly 11 includes a magnet assembly 12 which has separate electromagnets with cylindrical poles having their axis aligned with the filament 15B within the arc chamber 15. The source magnets produce higher efficiency of ion generation by causing electrons emitted from the filament 15B to spiral around the filament in a path to the walls of the arc chamber 15 serving as the anode and thus increase the ionization efficiency in the source. However, hard driving of the source magnets can affect arc stability.

A post-acceleration supply 41 is set to a prearranged value between 0 and 160 kilovolts to determine the amount of preset acceleration of the ion beam, in the post-acceleration system. This voltage also determines the terminal reference potential in terminal 25 in which is housed the ion source arrangement 10 and the mass analyzing system 20. All of the ion source operating voltages and the extraction system voltages are referenced to the terminal voltage set by the post-accel supply. Pre-accel supply 81 is set to a value between 0 and +20 kilovolts and that voltage is applied to the ion source chamber 15 where it serves as the ion source ground reference potential. The filament is d.c. biased to a voltage above the ion source chamber by the arc supply 61. The filament 15B is heated by passing electrical current therethrough from filament supply 60.

As shown, deceleration electrode 13B is directly connected to terminal potential and extraction electrode 13A and is supplied with voltage from focus supply 82 which can be set from 0 to-30 kilovolts. The ion beam is extracted from the source chamber by an extraction and accelerating field between the ion source chamber at the preset pre-accel supply potential and the extraction electrode at the preset focus supply voltage value. The value of the output of the pre-accel supply is set according to the amount of pre-acceleration of the beam that is desired. The value of the focus voltage is set during a beam tuning process to obtain the desired ion beam characteristics.

As shown in Fig. 1A, the Freeman ion source is operated from an electrical standpoint by coupling a filament power supply 60 across the filament 15B to supply high current at low voltage to the filament. An arc power supply 61 applies a voltage, which is typically clamped to a maximum of about 170 volts between the filament 15B and the arc chamber 15, with the arc chamber serving as an anode. Filament 15B generates thermal electrons which are accelerated through the gas species within the arc chamnber and toward the arc chamber walls to create a plasma of the ion species within the arc chamber 15.

A separate pre-accel (or extraction) power supply 62 provides a pre-analysis acceleration voltage of up to 40 kilovolts to the arc chamber 15. A suppression power supply 63 provides a slightly negative voltage of around -2 kilovolts to extraction electrode 13A, also known as the suppression electrode. The final electrode 13B is biased at terminal ground reference so that the final ion beam pre-analysis acceleration is determined by the value of the pre-analysis acceleration voltage applied to the arc chamber itself. Terminal ground reference is the value of the post-acceleration voltage applied to the terminal and the value of that voltage determines the final ion beam energy striking the target.

When the target wafer 50 is not intercepting all of the ion beam exiting the post-acceleration region, some of the ion beam falls on the beam stop 51. When the scan wheel carrying the wafers is totally out of the ion beam, all of the ion beam is collected in the beam stop 51 and the ion beam current can be accurately measured at this time. The beam stop arrangement includes suppression magnets 52 to prevent loss of secondary electrons and to maintain current measuring accuracy. The current collected on the beam stop is fed to a current to voltage converter 53. The output of the current to voltage converter is fed to a computer control system 75 which is used to perform dose calculations. A suitable current to voltage converter 53 and dose calculation system is described in detail in US-A-4 743 767 to Plumb et al.

A flood gun arrangement 54 is incorporated into the system to assist with avoiding charge build up on the surface of a wafer during implantation. The flood gun operation will also be controlled by a computer control system 75. Beam control vanes 55 in the extraction region of the ion source arrangement also function under computer control routines to apply a controlled degree of trim to the ion beam and thus to control the amount of beam current delivered to the wafer 50.

In accordance with the present invention, all externally applied fields between the mass analyzer and the wafer that will inhibit transport of low energy electrons to the wafer are eliminated. This ensures that only low energy electrons will be transported to the wafer, e.g., those that are trapped/confined within the beam plasma as it exits the region containing the mass resolving system. This includes systems such as dosimetry systems in front of the target wafers; all post-acceleration or deceleration systems that are in front of the target wafers; and all shuttered beam current equipment used for taking readings of the ion beam. Other equipment known to those skilled in the art generate various additional magnetic or electrostatic fields as well. Some equipment generates electric fields near the end of the beam line to prevent electrons from moving back up the line; other equipment generates magnetic fields just beyond the mass resolving system to measure the ion beam current on a shutter mechanism through the mass resolving aperture.

By removing all externally generated magnetic and electrostatic fields, the very low energy electrons created in the mass resolving system can be readily transported to the wafer together with low energy electrons generated by ionizing collisions with residual gas in the beam line.

Dosimetry readings can be taken behind the wafer 50 in the stop region 51, as explained hereinabove. Eliminating dosimetry readings before the wafer is implanted removes another cause of wafer charging.

All acceleration of the ion beam takes place prior to the beam entering the beam analyzing magnet. By eliminating all fields subsequent to the beam analyzing magnet from the implanter, the sources of fields are eliminated.

In the mass resolving system, a high energy incident ion beam generates secondary electrons. The secondary electron emission coefficient can vary from over 1 to about 50. Thus, if a small fraction of the beam impinges on the mass resolving system, a large quantity of secondary electrons will be generated having an energy of less than 20 eV.

Electrons can also be generated by collisions of the beam ions with residual gas molecules in the vacuum chamber. However, since ion implantation usually takes place in a high vacuum environment (less than 133·10⁻⁵ Pa = 10⁻⁵ Torr) the number of such ion/gas collisions is relatively small compared to the number of ion/solid collisions as the beam passes through the mass resolving system.

The wafer, situate in a field-free zone, does not get exposed to the number of electrostatic and magnetic forces that can vary its charge and inhibit the transport of electrons to the wafer. If, during exposure to the positively charged ions in the implantation beam, the wafer does become positively charged, the presence of a sufficient number of low energy electrons in the beam will ensure prompt and complete neutralization of the charge.

Further, within microseconds of a change occurring in the beam, i.e., a number of electrons are taken up by the wafer, additional electrons are produced and transported to the wafer. The beam maintains a space charge equilibrium that acts faster and more completely than devices such as an electron flood gun, to deliver additional electrons when needed to eliminate wafer charging.

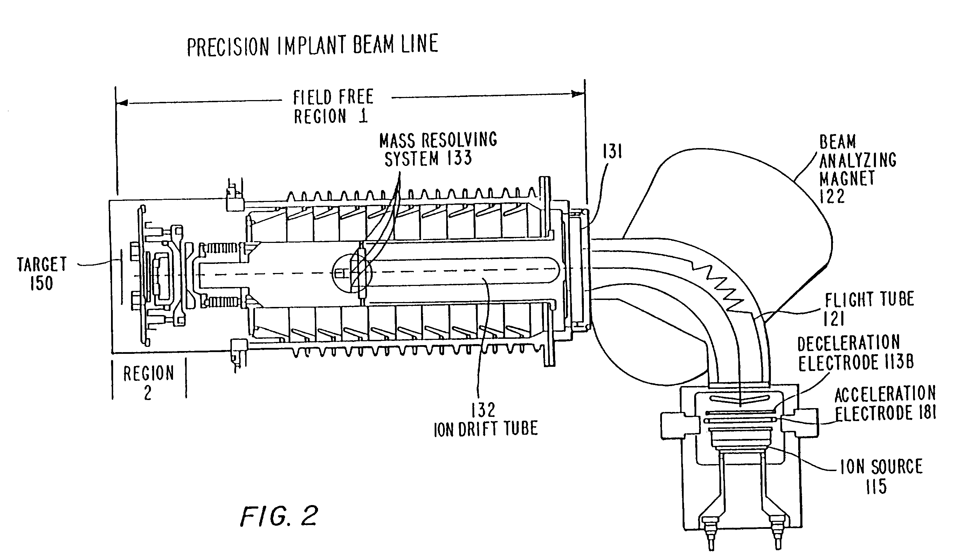

Referring now to Fig. 2, all common subsystems are numbered the same as in Figs. 1 and 1A, except for a prefix "1". The beam of ions is generated in an ion source chamber 115, accelerated by electrode 181 and its speed adjusted by deceleration electrode 113B. After exiting the chamber 115, the beam is passed along flight tube 121 and passed between beam analyzing magnets 122, where the beam is bent. The ion beam passes through a valve 131 to a mass resolving system 133, where the beam is resolved and the desired chemical species transported to the target 150 to be ion implanted.

It is apparent that the last externally applied field is at the bending magnet which selects the ion species to be transported to the wafer.

Other variations will suggest themselves to those skilled in the art and are meant to be included herein. The invention is meant only to be limited by the scope of the appended claims.

## Claims

1. An ion implanter comprising a source (115) of ions, a system (133) of resolving an ion beam to allow preselected chemical species of ions having a known mass to pass through an aperture, and a target (150) to be implanted,
**characterized** in
that all applied sources of electrostatic or magnetic fields are arranged remote from a region located between the mass resolving system (133) and the target to create a field free region, whereby the transport to the target (150) of low energy electrons generated in the implanter and trapped in the beam is made possible.

2. A method of ion implantation which comprises generating a beam of ions having a known mass in a chamber (115), and directing said beam through a mass resolving system (133) that allows only ions of said known mass to pass therethrough to a target (150) to be implanted,
**characterized** in
that electrons generated by collisions of said beam with said mass resolving system (133) and by the ionizing collision of said beam with residual gas molecules, are transported in the beam from said mass resolving system (133) to the target (150) in an environment free of all electrostatic and magnetic fields.

## Patentansprüche

1. Eine Ionenimplantationsanlage mit einer Quelle (115) für Ionen, einem System (133) zum Trennen eines Ionenstrahls, um eine vorher ausgewählte, chemische Spezies von Ionen mit einer bekannten Masse durch eine Blende durchzulassen, und einem Target (150), das implantiert werden soll,
dadurch **gekennzeichnet**,
daß alle Quellen von angelegten elektrostatischen oder magnetischen Feldern entfernt von einem Bereich angeordnet sind, der zwischen dem Massentrennsystem (133) und dem Target angeordnet ist, um einen feldfreien Bereich zu erzeugen, wodurch der Transport von niederenergetischen Elektronen, die in der Implantationsanlage erzeugt wurden und im Strahl eingefangen wurden, zum Target (150) ermöglicht wird.

2. Ein Verfahren zur Ionenimplantation, welches ein Erzeugen eines Strahls von Ionen mit einer bekannten Masse in einer Kammer (115) und ein Führen des Strahls durch ein Massentrennsystem (133) einschließt, das nur Ionen der bekannten Masse durch es hindurch zu einem Target (150), das implantiert werden soll, durchläßt
dadurch **gekennzeichnet**
daß Elektronen, die durch Stöße des Strahls mit dem Massentrennsystem (133) und durch den ionisierenden Stoß des Strahls mit den Restgasmolekülen erzeugt werden, im Strahl vom Massentrennsystem (133) zum Target (150) in einer Umgebung, die frei von allen elektrostatischen und magnetischen Feldern ist, transportiert werden.

## Revendications

1. Dispositif d'implantation ionique comprenant une source (115) d'ions, un système (133) de résolution d'un faisceau ionique destiné à permettre à des espèces chimiques pré-sélectionnées d'ions présentant une masse connue de passer au travers d'une ouverture, et une cible (150) à implanter,
caractérisé en ce que
toutes les sources appliquées de champs électrostatiques ou magnétiques sont agencées à distance d'une région située entre le système de résolution de masse (133) et la cible afin de créer une région dépourvue de champ, d'où il résulte que le transport vers la cible (150) des électrons de faible énergie générés dans le dispositif d'implantation et piégés dans le faisceau, est rendu possible.

2. Procédé d'implantation ionique comprenant la génération d'un faisceau d'ions présentant une masse connue dans une chambre (115), et le fait de diriger ledit faisceau au travers d'un système de résolution de masse (133) qui ne permet que le passage au travers de celui-ci des ions de ladite masse connue, vers une cible (150) à implanter,
caractérisé en ce que
des électrons générés par des collisions dudit faisceau avec ledit système de résolution de masse (133) et par la collision ionisante dudit faisceau avec des molécules de gaz résiduelles, sont transportés dans le faisceau depuis ledit système de résolution de masse (133) vers la cible (150) dans un environnement dépourvu de tous champs électrostatiques et magnétiques.
